(19) **Europäisches Patentamt / European Patent Office / Office européen des brevets**

(11) **EP 3 231 057 B1**

(12) **FASCICULE DE BREVET EUROPEEN**

(45) Date de publication et mention
de la délivrance du brevet:
**01.04.2020 Bulletin 2020/14**

(21) Numéro de dépôt: **15817099.3**

(22) Date de dépôt: **08.12.2015**

(51) Int Cl.:
**H02J 7/00** *(2006.01)*

(86) Numéro de dépôt international:
**PCT/EP2015/079033**

(87) Numéro de publication internationale:
**WO 2016/091910 (16.06.2016 Gazette 2016/24)**

(54) **PROCÉDÉ ET DISPOSITIF DE DÉTECTION D'UNE SURCHARGE D'UN ACCUMULATEUR D'UNE BATTERIE**

VERFAHREN UND VORRICHTUNG ZUR ERKENNUNG EINES ÜBERLADEZUSTANDES EINES AKKUMULATORS EINER BATTERIE

METHOD AND DEVICE FOR DETECTING AN OVERCHARGING OF AN ACCUMULATOR OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.12.2014 FR 1402794**

(43) Date de publication de la demande:
**18.10.2017 Bulletin 2017/42**

(73) Titulaire: **NAVAL GROUP**
**75015 Paris (FR)**

(72) Inventeur: **PIERRE, Nicolas**
**29000 Quimper (FR)**

(74) Mandataire: **Lavoix**
**2, place d'Estienne d'Orves**
**75441 Paris Cedex 09 (FR)**

(56) Documents cités:
**US-A1- 2011 298 626     US-A1- 2013 140 886**

**Description**

La présente invention concerne la détection d'une surcharge d'un accumulateur d'une batterie comprenant un ensemble de branches parallèles, chaque branche comportant des accumulateurs disposés en série.

Une opération de charge des batteries comportant de tels accumulateurs s'effectue par application d'une tension de charge aux bornes des branches de la batterie.

Certains accumulateurs, notamment ceux comportant du Lithium, ne supportent pas la surcharge. En effet, un accumulateur Lithium-ion soumis à une surcharge donne lieu à un phénomène dit de « venting » correspondant à un dégagement de gaz (en-dehors de l'enveloppe mécanique de l'accumulateur, pouvant s'accompagner d'un fin nuage d'électrolyte, et conduire à des dégradations (échauffement, surpression, voire explosion).

Une opération de charge des batteries comportant de tels accumulateurs doit donc être associée à une surveillance de la batterie pour détecter d'éventuels cas de surcharge et stopper très vite la charge.

Traditionnellement, la tension aux bornes des accumulateurs est surveillée, voire pilotée, par un système de gestion de batterie, nommé BMS (« Battery Management System » en anglais) qui peut déclencher une alarme ou une coupure de charge si la tension d'un accumulateur devient trop élevée. Toutefois, des dysfonctionnements ont lieu dans ces systèmes BMS, du fait du grand nombre de composants électroniques nécessaires et il est ainsi souhaitable de disposer de solutions variées de surveillance pour éviter les modes communs de défaillances.

D'autres solutions pour empêcher des dysfonctionnements dans les batteries, sont basées sur la mesure de courants circulant dans les branches, comme décrit par exemple dans le document EP13008739 A2 ou dans le document US 2011/298626 A1.

Toutefois, ces solutions de l'art antérieur donnent lieu à des coupures ou alarmes dans des cas où aucun accumulateur n'est en réalité en surcharge.

A cet effet, suivant un premier aspect, l'invention propose un procédé de détection d'une surcharge d'un accumulateur d'une batterie comprenant un ensemble de branches parallèles, chaque branche comportant des accumulateurs disposés en série, ledit procédé étant caractérisé en ce qu'il comprend les étapes suivantes :

- collecter les mesures des courants circulant dans les branches de la batterie ;
- identifier au moins un écart de courant dans une branche dudit ensemble de branches par rapport à au moins une autre branche dudit ensemble de branches en fonction des mesures de courant collectées ;
- déterminer un niveau d'état de charge de ladite branche ; et
- détecter une surcharge d'un accumulateur dans ladite branche en fonction d'au moins ledit écart de courant identifié et du niveau d'état de charge déterminé.

La présente invention permet de limiter les cas erronés de détection de surcharge identifiés avec les solutions de l'art antérieur.

En particulier, la présente invention permet de distinguer les écarts de courant entre branches dus à une surcharge d'un accumulateur d'une branche et les écarts de courant dus à des branches de la batterie ayant des capacités de stockage différentes, évitant ainsi les problèmes, rencontrés dans l'art antérieur, de déconnexions intempestives d'une telle branche lorsqu'elle ne comporte pas d'accumulateur en surcharge.

Dans des modes de réalisation, le procédé de détection d'une surcharge d'un accumulateur d'une batterie suivant l'invention comporte en outre une ou plusieurs des caractéristiques suivantes :

- la détection d'une surcharge comprend le test d'au moins une condition relative à l'écart de courant identifié, ladite condition à tester relative à l'écart de courant identifié étant fonction du niveau d'état de charge déterminé ;
- on calcule une différence entre le courant mesuré dans ladite branche (B1,..., BN) et un courant de référence déterminé en fonction d'au moins le courant mesuré dans l'autre branche ;
- ladite différence est comparée à un seuil ;
- une surcharge d'un accumulateur dans ladite branche est détectée en fonction du résultat de ladite comparaison et du niveau de charge déterminé ;
- on identifie un premier écart de courant dans ladite branche à un premier temps en fonction d'un premier seuil d'écart de courant, on identifie un deuxième écart de courant dans ladite branche à un deuxième temps en fonction d'un deuxième seuil d'écart de courant distinct du premier seuil d'écart de courant, et une surcharge d'un accumulateur dans ladite branche est détectée en fonction dudit premier écart de courant, dudit deuxième écart de courant et du niveau d'état de charge déterminé ;
- on distingue au moins une première plage de niveaux d'état de charge et une deuxième plage, postérieure à ladite première plage, de niveaux d'état de charge, et si un niveau d'état de charge de la branche est déterminé dans la deuxième plage, une surcharge d'un accumulateur dans ladite branche est détectée si l'écart de courant identifié dans ladite branche franchit d'abord un premier seuil et ultérieurement franchit un deuxième seuil, le signe des premier et deuxième seuil étant opposé ;
- le premier seuil est égal à l'opposé du deuxième seuil ;
- une surcharge d'un accumulateur dans ladite branche est détectée, pour un niveau d'état de charge déterminé dans la première plage, dès que l'écart de courant identifié dans ladite branche franchit le premier seuil.

Suivant un deuxième aspect, la présente invention propose un programme d'ordinateur pour la détection d'une surcharge d'un accumulateur d'une batterie comprenant un ensemble de branches parallèles comportant chacune des accumulateurs disposés en série, ledit produit programme d'ordinateur comportant des instructions logicielles qui, lorsqu'elles sont exécutées sur des moyens de calcul, mettent en œuvre les étapes d'un procédé selon le premier aspect de l'invention.

Suivant un troisième aspect, la présente invention propose un dispositif de détection d'une surcharge d'un accumulateur d'une batterie comprenant un ensemble de branches parallèles chaque branche comportant des accumulateurs disposés en série, ledit dispositif étant caractérisé en ce qu'il est adapté pour collecter les mesures des courants circulant dans les branches de la batterie, pour identifier au moins un écart de courant dans une branche dudit ensemble de branches par rapport à au moins une autre branche dudit ensemble de branches en fonction des mesures de courant collectées, pour déterminer un niveau d'état de charge de ladite branche ; et pour détecter une surcharge d'un accumulateur dans ladite branche en fonction d'au moins ledit écart de courant identifié et du niveau d'état de charge déterminé.

Ces caractéristiques et avantages de l'invention apparaîtront à la lecture de la description qui va suivre, donnée uniquement à titre d'exemple, et faite en référence aux dessins annexés, sur lesquels :

- la figure 1 représente une vue d'un système de batterie dans un mode de réalisation de l'invention ;
- la figure 2 est une vue d'un graphe représentant l'évolution de la tension d'un accumulateur d'une batterie en fonction de l'état de charge de l'accumulateur dans un mode de réalisation de l'invention ;
- la figure 3 est un organigramme d'étapes d'un procédé dans un mode de réalisation de l'invention.

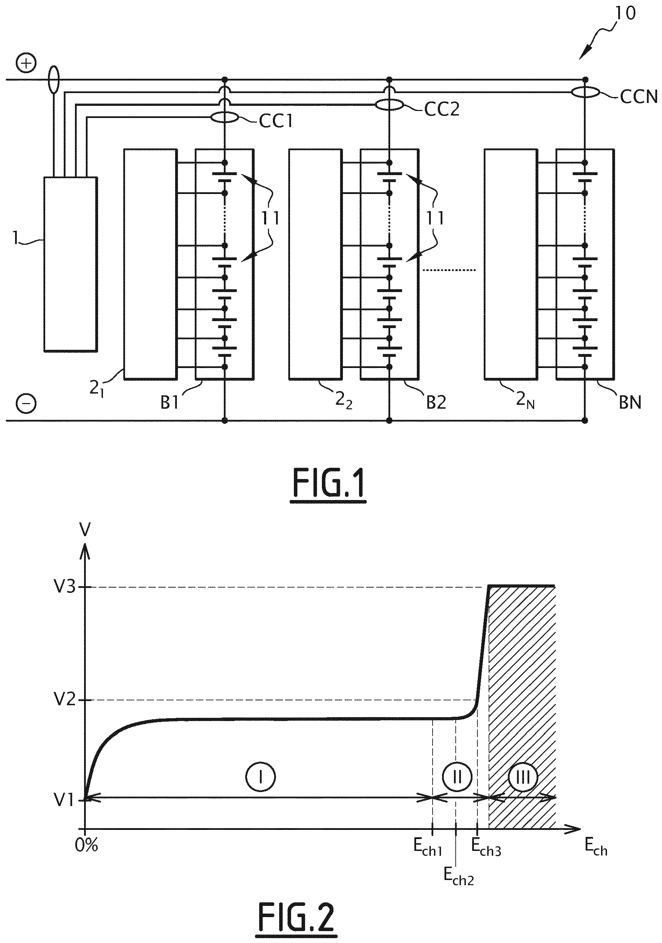

La figure 1 est une vue d'un système de batterie 10 dans un mode de réalisation de l'invention.

Le système de batterie 10 comporte une batterie comprenant N packs, encore appelées branches, B1, B2, ... BN, et disposés en parallèle.

N est un nombre entier supérieur ou égal à 2.

La tension entre les bornes positive et négative de la batterie est égale à la tension aux bornes de chaque branche.

Chaque branche comporte des accumulateurs 11 raccordés en série.

Par exemple, le nombre d'accumulateurs dans une branche est égal à M, M est un nombre entier supérieur ou égal à 2.

De manière connue, un accumulateur est une brique énergétique élémentaire adaptée pour stocker de l'énergie.

Le système de batterie 10 comporte un dispositif de surveillance de surcharge 1.

Dans un mode de réalisation, la batterie 10 est de type Li-ion et les accumulateurs sont de technologie LFP (Lithium Fer Phosphate).

La batterie 10 est par exemple destinée à l'alimentation électrique d'un sous-marin.

Dans le mode de réalisation considéré, le système de batterie 10 comporte en outre des dispositifs de contrôle de la tension des accumulateurs, référencés $2_1$, $2_i$, ..., $2_N$.

Chaque dispositif $2_i$ de contrôle de la tension des accumulateurs est associé à une branche respective Bi et est adapté pour mesurer et piloter la tension aux bornes de chaque accumulateur 11 de la branche Bi, i = 1 à N.

Par exemple, le dispositif 2i de contrôle de la tension des accumulateurs est adapté pour procéder à un équilibrage des tensions de fonctionnement aux bornes des accumulateurs en série dans la branche Bi afin que tous les accumulateurs de la branche Bi terminent leur charge de manière synchrone. En effet, au cours de la charge, tous les accumulateurs ne se chargent pas à la même vitesse du fait des disparités de caractéristiques intrinsèques entre accumulateurs. Le dispositif 2i de contrôle de la tension des accumulateurs décharge alors les accumulateurs les plus chargés de la branche Bi, et au fur et à mesure les charges des accumulateurs au sein de la branche Bi s'égalisent.

Le dispositif 2i de contrôle de la tension des accumulateurs est en outre adapté pour, lorsque la tension d'un accumulateur de la branche Bi atteint la tension limite haute de l'accumulateur, déclencher un arrêt de charge de la branche Bi de l'accumulateur (dans d'autres modes de réalisation, seul un arrêt de charge de l'accumulateur est déclenché) par exemple par actionnement d'interrupteurs (non représentés).

Le système de batterie 10 comporte en outre des capteurs de courant CC1, CC2, ..., CCN.

Le capteur de courant CCi est adapté pour mesurer régulièrement le courant circulant dans la branche Bi du système de batterie 10, i = 1 à N.

La figure 2 représente la courbe de l'évolution de la tension V d'un accumulateur 11 en fonction de l'état de charge $E_{ch}$ de l'accumulateur.

L'état de charge indique la quantité d'énergie stockée par rapport à la quantité maximale stockable par l'accumulateur et correspondant à une tension de fonctionnement nominale V2. (100% d'état de charge signifie que l'on a atteint la tension maximum de charge de l'accumulateur fixée par le constructeur et qui ne doit pas être dépassée sous peine de rentrer dans une zone de fonctionnement dangereux. Physiquement, lorsque cette tension maximum est atteinte, pour du LFP, cela veut dire que tous les sites d'insertions des ions lithium sont remplis. Si l'on va au-dessus, on commence à détériorer l'accumulateur et ses électrodes)

L'état de charge de l'accumulateur est par exemple exprimé en pourcentage.

La quantité d'énergie, stockée ou stockable, d'une batterie est par exemple mesurée en watt-heure (Wh) et elle correspond à une capacité de la batterie, par exemple mesurée en ampère-heure (Ah).

La valeur V1 représente la valeur de tension minimale de fonctionnement de l'accumulateur, V2 représente la valeur de tension maximale de charge de l'accumulateur, tandis que V3 représente la valeur de tension de saturation de l'accumulateur lors d'une surcharge.

Dans le cas d'un accumulateur Li-ion de technologie LFP, typiquement : V1 = 2,5V, V2 = 3,6 V et V3 = 5V.

La courbe représentée en figure 2 présente un plateau de tension, zone dans laquelle la pente de la tension en fonction de l'état de charge est très faible, puis la tension remonte de façon brutale dans les 5 derniers pourcents de charge avant l'atteinte de la tension maximale de charge V2.

Si la charge se poursuit au-delà, l'accumulateur arrive en saturation à tension limite haute V3, tension à laquelle il peut rester plus ou moins longtemps avant de partir en « venting », suivant le régime de charge. Plus celui-ci est bas et plus l'accumulateur surchargé mettra de temps avant que le phénomène de « venting » ne survienne.

Pour qu'il y ait surcharge sur un accumulateur 11 en série au sein d'une branche Bi, cet accumulateur 11 doit se trouver dans les conditions suivantes :

- il sature à la tension V3 ; et
- il continue de voir un courant de charge, i.e. les autres accumulateurs en série avec lui présentent des tensions inférieures aux tensions des accumulateurs des autres branches du fait de la mise en parallèle des packs.

On notera que si un accumulateur 11 dans une branche Bi est en surcharge, cela signifie que le dispositif $2_i$, de contrôle de la tension des accumulateurs dans la branche Bi de l'accumulateur 11 n'a pas correctement fonctionné et n'a pas procédé à un équilibrage, ni déclenché d'arrêt de charge lorsque la tension de l'accumulateur a atteint la tension limite haute V3.

Dans un mode de réalisation de l'invention, l'espace (V, Ech) de l'accumulateur est subdivisé en zones distinctes.

Chaque zone correspond à une phase de charge.

Les phases de charges sont définies par une ou des plages respectives de valeurs d'état de charge.

Dans le cas présent, trois zones I, II et III sont considérées et sont repérées sur la figure 2 :

- la zone I associée à un état de charge de l'accumu-lateur compris entre [0, $Ech_1$] correspond à un début de charge ;
- la zone II associée à un état de charge de l'accumu-lateur compris entre [$Ech_1$, $Ech_3$] correspond à une fin de charge ;
- la zone III associée à un état de charge de l'accu-mulateur supérieur à $Ech_3$ correspond à une surten-sion, et donc à terme à une surcharge ; sur la figure 2, la zone de surcharge, correspondant à l'atteinte par la tension de l'accumulateur de la saturation en tension V3 est indiquée par des rayures.

Dans le cas d'un accumulateur Li-ion de technologie LFP, $Ech_1$ = 90%, $Ech_3$ = 100%.

Dans un mode de réalisation, on considère en outre l'état de charge de chaque branche de la batterie, et similairement à ce qui a été décrit ci-dessus en référence aux accumulateurs, des phases de charge d'une branche de batterie sont définies par une ou des plages respectives des valeurs d'état de charge.

Dans le mode de réalisation, trois zones ZI, ZII et ZIII sont considérées :

- la zone ZI associée à un état de charge d'une bran-che compris entre [0, $Ech_1$] correspond à un début de charge ;
- la zone ZII associée à un état de charge d'une bran-che compris entre [$Ech_1$, $Ech_3$] correspond à une fin de charge ;
- la zone III associée à un état de charge d'une bran-che, supérieur à $Ech_3$ correspond à une surtension, et donc à terme à une surcharge.

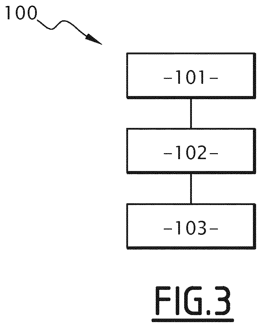

Dans le mode de réalisation considéré, le dispositif de surveillance de surcharge 1 est adapté pour mettre en œuvre l'ensemble d'étapes 100 décrit ci-dessous en référence à la figure 3.

Dans un mode de réalisation, le dispositif de surveillance de surcharge 1 comprend une mémoire et un microprocesseur. La mémoire stocke des instructions logicielles, qui lorsqu'elles sont exécutées par le microprocesseur du dispositif de surveillance de surcharge 1, mettent en œuvre l'ensemble d'étapes 100.

L'ensemble d'étapes 100 est par exemple réitéré par le dispositif de surveillance de surcharge 1 à chaque instant d'itération $T_n = T_0 + n/F0$ pendant la charge de la batterie, où $T_0$ est l'instant de début de charge de la batterie.

Dans une étape 101, le dispositif de surveillance de surcharge 1 est adapté pour collecter en temps réel les mesures, réalisées par les capteurs de courant CCi, i = 1 à N, des courants dans les branches Bi et le dispositif de surveillance de surcharge 1 est en outre adapté pour déterminer l'état de charge courant de la batterie ou de chaque branche Bi.

Dans une étape 102, le dispositif de surveillance de surcharge 1 est adapté pour identifier un écart de courant dans une branche par rapport à au moins une autre desdites branches en fonction des mesures de courant collectées à l'étape 101 et pour, en fonction de l'écart de courant identifié et du niveau d'état de charge déterminé (de la batterie ou de chaque branche Bi), détecter la présence ou l'absence d'une surcharge d'un accumulateur dans la branche Bi.

Dans une étape 103, dans le cas où une branche $Bi_0$ a été détectée comme étant en surcharge à l'étape 102, le dispositif de surveillance de surcharge 1 est adapté pour déclencher l'arrêt de la charge dans la branche $Bi_0$. Un tel arrêt de la charge dans la branche $Bi_0$ est déclenché par exemple en émettant une alarme ou en actionnant des interrupteurs (non représentés) déconnectant la branche $Bi_0$ des bornes d'application de la tension de charge de la batterie.

Dans un mode de réalisation, les accumulateurs sont équilibrés avant la recharge de sorte qu'ils soient dans un état de charge supposé identique et connu, l'évaluation de l'état de charge se faisant par le biais des capteurs de courant. Par exemple, dans une étape préliminaire, avant la recharge de la batterie, les accumulateurs 11 de la batterie sont équilibrés à un niveau commun fixé de décharge bas (par exemple correspondant à un niveau de tension V1) par les dispositifs $2_i$, de contrôle de la tension des accumulateurs. Ainsi dans un mode de réalisation, le dispositif de surveillance de surcharge 1 est adapté pour déterminer l'état de charge courant à l'étape 101 en le prenant égal à l'état de charge de la batterie, calculé par le comptage du total des ampères stockés par la batterie, en fonction des mesures de courant collectés depuis $T_0$.

Un tel procédé permet de réduire le risque de détecter des surcharges alors qu'il n'y en a pas.

Dans un mode de réalisation, les opérations suivantes sont réalisées par le dispositif de surveillance de surcharge 1 à l'étape 102 à l'instant d'itération $T_n$.

Pour identifier une différente de répartition du courant entre les branches, le dispositif de surveillance de surcharge 1 calcule la valeur d'un courant de référence $I_{ref\_n}$ égal à la somme des courants couramment mesurées dans les N branches divisée par le nombre N de branches.

Puis le dispositif de surveillance de surcharge 1 calcule la différence $\Delta I_{Bi\_n}$ entre la mesure du courant dans la branche Bi couramment collectée à l'étape 100, nommée $I_{Bi\_n}$, et le courant de référence $I_{ref\_n}$, pour i = 1 à N, soit :

$$I_{ref\_n} = (\Sigma_{i=1 \text{ à } N} I_{Bi\_n})/N ;$$

$$\Delta I_{Bi\_n} = I_{ref\_n} - I_{Bi\_n}.$$

Puis le dispositif de surveillance de surcharge 1 teste les conditions suivantes cond(I) et cond(II) pour i = 1 à N et ainsi détecte la présence ou l'absence d'une surcharge d'un accumulateur dans une branche :

- cond(I) : si l'état de charge déterminé à l'étape 101 de l'instant d'itération $T_n$ est égal à ZI et que $\Delta I_{Bi\_n} > \Delta_{seuil}$, alors il existe un accumulateur 11 en surcharge dans la branche Bi ;
- cond(II) : s'il est détecté, au cours de la charge dans la zone ZII, le dépassement du seuil $\Delta_{seuil}$, puis le passage en-dessous du seuil -$\Delta_{seuil}$, alors il existe un accumulateur 11 en surcharge dans la branche Bi ; la mise en œuvre de la condition cond(II) est par exemple la suivante : si l'état de charge déterminé à l'étape 101 de l'instant d'itération $T_n$ est égal à ZII, que $\Delta I_{Bi\_n}, < - \Delta_{seuil}$ et qu'il a été déterminé au cours de la charge dans la zone ZII et à un instant antérieur, par exemple nommé $T_m(T_m<T_n)$ que $\Delta I_{Bi\_m} > \Delta_{seuil}$, alors il existe un accumulateur 11 en surcharge dans la branche Bi.

La valeur seuil $\Delta_{seuil}$ est une valeur positive fixée expérimentalement.

On notera d'ailleurs que dans des modes de réalisation, il pourra être utilisé une valeur de seuil $\Delta_{seuil1}$ pour tester la condition cond(I) et une valeur de seuil distincte, $\Delta_{seuil2}$, pour tester la condition cond(II)) le franchissement de ce seuil $\Delta_{seuil2}$ et de son opposé - $\Delta_{seuil2}$. Dans un mode de réalisation, des valeurs distinctes sont prises pour le seuil positif $\Delta_{seuil2\_1}$ et le seuil négatif -$\Delta_{seuil2\_2}$ dont les franchissements successifs sont détectés par la condition cond(II).

Si le test de ces conditions cond(I) et cond(II) pour chaque i, i = 1 à n, ne donne pas lieu à la détection de surcharge par le dispositif de surveillance de surcharge 1, ce dernier conclut à l'absence de surcharge au sein de la batterie à l'instant $T_n$.

Considérons les cas de figure suivants :
Cas A : un accumulateur 11 dans une branche $Bi_0$ entre en surcharge dans la zone ZI.

Dans ce cas, la surtension est engendrée au niveau de la branche $Bi_0$ par l'accumulateur 11 en surcharge (par exemple supérieure à 1,5V), ce qui donne l'illusion aux autres branches que la branche $Bi_0$ a un certain pourcentage d'état de charge de plus qu'elles. Naturellement, le courant dans la branche $Bi_0$ va alors diminuer et les autres branches vont se répartir un courant supplémentaire, au total équivalent à la diminution du courant dans cette branche $Bi_0$. Ainsi, les autres branches compensent leur « retard » sur la branche $Bi_0$.

Cas B : un accumulateur 11 dans une branche $Bi_0$ entre en surcharge dans la zone ZII. La branche $Bi_0$ prend alors du retard dans sa charge car l'augmentation de tension à ses bornes, due à la surtension de l'accumulateur en défaut, ne correspond pas à une réelle augmentation de l'état de charge de la branche. Une fois que la tension de cet accumulateur atteint la tension de saturation, la branche $Bi_0$ doit alors rattraper le retard d'état de charge accumulé en acceptant une élévation de courant.

Cas C : Dans la zone ZIII, les autres branches imposant une tension maximale à la branche $Bi_0$, les accumulateurs de la branche $Bi_0$ ont une tension suffisamment élevée pour empêcher la branche $Bi_0$ d'aller au-delà d'une tension où un accumulateur peut saturer à 5V si le dispositif $2i_0$ de contrôle de la tension des accumulateurs n'a pas fonctionné.

Ainsi, quand l'état de charge est ZI, le dépassement par $\Delta I_{Bio\_n}$ de la valeur-seuil $\Delta_{seuil}$ est caractéristique de la présence d'un accumulateur en surcharge dans la branche $Bi_0$, comme décrit par le cas A.

Quand l'état de charge est ZII et que la différence entre la mesure du courant dans la branche $Bi_0$ et le courant de référence $I_{ref\_n}$, devient tout d'abord supérieure au premier seuil égal à $\Delta_{seuil}$, puis inférieure au deuxième seuil égal à $-\Delta_{seuil}$, cela signifie qu'un accumulateur n'a pas correctement été équilibré et qu'il est en surcharge.

Le franchissement du deuxième seuil après le premier permet de détecter qu'il y a eu dysfonctionnement de la gestion en tension d'au moins un accumulateur. Si la détection de surcharge ne prenait en compte que le franchissement du premier seuil avait été considéré, une surcharge aurait pu été signalée de façon erronée si la branche $Bi_0$ était globalement plus faible que les autres branches, sans que cela signifie qu'il y ait surcharge d'un accumulateur dans la branche $Bi_0$.

Dans le cas où la batterie comporte une branche de capacité plus faible que les autres branches, il y aura bien en zone ZII un franchissement de $\Delta_{seuil}$, mais pas de franchissement ultérieur de $-\Delta_{seuil}$, donc la présente invention évitera une détection erronée de surcharge dans un tel cas.

Dans un mode de réalisation décrit ci-dessus, la condition à tester relative à un écart de courant dans une branche Bi comprend le calcul de la différence entre la mesure du courant dans la branche Bi et un courant de référence égal à la moyenne des courants circulant dans les différentes branches, puis à la comparaison de cette différence avec un seuil. Dans d'autres modes de réalisation, la condition à tester relative à un écart de courant dans une branche Bi prend des formes différentes, par exemple le courant de référence est choisi égal à un courant circulant dans une autre branche.

La présente invention propose ainsi une solution pour détecter des problèmes de surcharges au sein d'une batterie et notamment pour détecter et pallier des dysfonctionnements des dispositifs de contrôle de la tension des accumulateurs de la batterie. Dans un mode de réalisation, l'invention permet ainsi de réaliser la détection de surcharge à partir des seules mesures de courant, et indépendamment de mesures de tension des accumulateurs.

**Revendications**

1. Procédé de détection d'une surcharge d'un accumulateur (11) d'une batterie (10) comprenant un ensemble de branches parallèles (B1,..., BN), chaque branche comportant des accumulateurs disposés en série, ledit procédé comprenant les étapes suivantes :

   - (i) collecter les mesures des courants circulant dans les branches de la batterie ;
   - (ii) identifier au moins un écart de courant dans une branche dudit ensemble de branches par rapport à au moins une autre branche dudit ensemble de branches en fonction des mesures de courant collectées ;
   - (iii) déterminer un niveau d'état de charge de ladite branche ; et
   - (iv) détecter une surcharge d'un accumulateur dans ladite branche en fonction d'au moins ledit écart de courant identifié et du niveau d'état de charge déterminé.

2. Procédé de détection d'une surcharge d'un accumulateur (11) selon la revendication 1, selon lequel la détection d'une surcharge comprend le test d'au moins une condition relative à l'écart de courant identifié, ladite condition à tester relative à l'écart de courant identifié étant fonction du niveau d'état de charge déterminé.

3. Procédé de détection d'une surcharge d'un accumulateur (11) selon la revendication 1 ou 2, selon lequel :

   - on calcule une différence entre le courant mesuré dans ladite branche (B1,..., BN) et un courant de référence déterminé en fonction d'au moins le courant mesuré dans l'autre branche,
   - ladite différence est comparée à un seuil ; et
   - une surcharge d'un accumulateur dans ladite branche est détectée en fonction du résultat de ladite comparaison et du niveau d'état de charge déterminé.

4. Procédé de détection d'une surcharge d'un accumulateur (11) selon l'une quelconque des revendications précédentes, selon lequel un premier écart de courant dans ladite branche (B1,..., BN) identifié à un premier temps est comparé à un premier seuil d'écart de courant, un deuxième écart de courant dans ladite branche identifié à un deuxième temps est comparé à un deuxième seuil d'écart de courant distinct du premier seuil d'écart de courant, et une surcharge d'un accumulateur dans ladite branche est détectée en fonction dudit premier écart de courant, dudit deuxième écart de courant et du niveau d'état de charge déterminé.

5. Procédé de détection d'une surcharge d'un accumulateur (11) selon l'une quelconque des revendications précédentes, selon lequel on distingue au moins une première plage (ZI) de niveaux d'état de charge et une deuxième plage (ZII), postérieure à ladite première plage, de niveaux d'état de charge, et si un niveau d'état de charge de la branche est déterminé dans la deuxième plage, une surcharge d'un accumulateur dans ladite branche est détectée si l'écart de courant identifié dans ladite branche franchit d'abord un premier seuil et ultérieurement franchit un deuxième seuil, le signe des premier et deuxième seuil étant opposés.

6. Procédé de détection d'une surcharge d'un accumulateur (11) selon la revendication 5, le premier seuil étant égal à l'opposé du deuxième seuil.

7. Procédé de détection d'une surcharge d'un accumulateur selon l'une quelconque des revendications 5 ou 6, selon lequel une surcharge d'un accumulateur (11) dans ladite branche (B1,..., BN) est détectée, pour un niveau d'état de charge déterminé dans la première plage, dès que l'écart de courant identifié dans ladite branche franchit le premier seuil.

8. Dispositif de détection (1) d'une surcharge d'un accumulateur (11) d'une batterie (10) comprenant un ensemble de branches parallèles (B1,..., BN), chaque branche comportant des accumulateurs disposés en série, ledit dispositif étant adapté pour collecter les mesures des courants circulant dans les branches de la batterie, pour identifier au moins un écart de courant dans une branche dudit ensemble de branches par rapport à au moins une autre branche dudit ensemble de branches en fonction des mesures de courant collectées, pour déterminer un niveau d'état de charge de ladite branche ; et pour détecter une surcharge d'un accumulateur dans ladite branche en fonction d'au moins ledit écart de courant identifié et du niveau d'état de charge déterminé.

9. Dispositif de détection (1) d'une surcharge d'un accumulateur (11) selon la revendication 8, adapté pour détecter ladite surcharge au moins en testant une condition relative à l'écart de courant identifié, ladite condition à tester relative à l'écart de courant identifié étant fonction du niveau d'état de charge déterminé.

10. Dispositif de détection (1) d'une surcharge d'un accumulateur (11) selon la revendication 8 ou 9, adapté pour calculer une différence entre le courant mesuré dans ladite branche et un courant de référence déterminé en fonction d'au moins le courant mesuré dans l'autre branche, pour comparer ladite différence à un seuil ; et pour détecter une surcharge d'un accumulateur dans ladite branche (B1,..., BN) en fonction du résultat de ladite comparaison et du niveau d'état de charge déterminé.

11. Dispositif de détection (1) d'une surcharge d'un accumulateur (11) selon l'une quelconque des revendications 8 à 10, adapté pour identifier un premier écart de courant dans ladite branche à un premier temps et le comparer à un premier seuil d'écart de courant, pour identifier un deuxième écart de courant dans ladite branche à un deuxième temps et le comparer à un deuxième seuil d'écart de courant distinct du premier seuil d'écart de courant, et pour détecter une surcharge d'un accumulateur dans ladite branche (B1,..., BN) en fonction dudit premier écart de courant, dudit deuxième écart de courant et du niveau d'état de charge déterminé.

12. Dispositif de détection (1) d'une surcharge d'un accumulateur (11) selon l'une quelconque des revendications 8 à 11, adapté pour, une première plage de niveaux d'état de charge (ZI) et une deuxième plage (ZII), postérieure à ladite première plage, de niveaux d'état de charge de la branche, étant définies, détecter une surcharge d'un accumulateur dans ladite branche si, le niveau d'état de charge de la branche étant dans la deuxième plage, l'écart de courant identifié dans ladite branche franchit d'abord un premier seuil et ultérieurement franchit un deuxième seuil, le signe des premier et deuxième seuil étant opposés.

13. Dispositif de détection (1) d'une surcharge d'un accumulateur (11) selon la revendication 12, dans lequel le premier seuil étant égal à l'opposé du deuxième seuil.

14. Dispositif de détection (1) d'une surcharge d'un accumulateur selon l'une quelconque des revendications 12 ou 13, adapté pour détecter une surcharge d'un accumulateur (11) dans ladite branche (B1,..., BN), dès que l'écart de courant identifié dans ladite branche franchit le premier seuil, pour un niveau d'état de charge déterminé dans la première plage.

15. Produit programme d'ordinateur comprenant des instructions qui conduisent le dispositif selon la revendication 8 à exécuter les étapes du procédé selon la revendication 1.

**Patentansprüche**

1. Verfahren zum Detektieren einer Überladung eines Akkumulators (11) einer Batterie (10), welche eine Gruppe von parallelen Zweigen (B1, ..., BN) aufweist, wobei jeder Zweig Akkumulatoren aufweist, welche in Reihe angeordnet sind, wobei das besagte Verfahren die folgenden Schritte aufweist:

- (i) Sammeln der Messungen von Strömen, welche in den Zweigen der Batterie fließen,
- (ii) Identifizieren von mindestens einer Stromabweichung in einem Zweig der besagten Gruppe von Zweigen im Vergleich zu mindestens einem anderen Zweig der besagten Gruppe von Zweigen in Abhängigkeit von den gesammelten Strommessungen,
- (iii) Ermitteln eines Ladezustand-Niveaus des besagten Zweigs, und
- (iv) Detektieren einer Überladung eines Akkumulators in dem besagten Zweig in Abhängigkeit von zumindest der besagten identifizierten Stromabweichung und von dem ermittelten Ladezustand-Niveau.

2. Verfahren zum Detektieren einer Überladung eines Akkumulators (11) gemäß Anspruch 1, gemäß welchem das Detektieren einer Überladung aufweist das Testen zumindest einer Bedingung, welche die identifizierte Stromabweichung betrifft, wobei die besagte zu testende Bedingung, welche die identifizierte Stromabweichung betrifft, abhängig von dem ermittelten Ladezustand-Niveau ist.

3. Verfahren zum Detektieren einer Überladung eines Akkumulators (11) gemäß Anspruch 1 oder 2, gemäß welchem:

- man eine Differenz berechnet zwischen dem Strom, welcher in dem besagten Zweig (B1, ..., BN) gemessen wird, und einem Referenzstrom, welcher in Abhängigkeit von zumindest dem Strom ermittelt wird, welcher in dem anderen Zweig gemessen wird,
- die besagte Differenz mit einem Schwellwert verglichen wird, und
- eine Überladung eines Akkumulators in dem besagten Zweig detektiert wird in Abhängigkeit von dem Ergebnis des besagten Vergleichs und von dem ermittelten Ladezustand-Niveau.

4. Verfahren zum Detektieren einer Überladung eines Akkumulators (11) gemäß irgendeinem der vorherigen Ansprüche, gemäß welchem eine erste Stromabweichung in dem besagten Zweig (B1, ..., BN), welche zu einer ersten Zeit identifiziert wird, verglichen wird mit einem ersten Stromabweichung-Schwellwert, eine zweite Stromabweichung in dem besagten Zweig, welche zu einer zweiten Zeit identifiziert wird, verglichen wird mit einem zweiten Stromabweichung-Schwellwert, welcher von dem ersten Stromabweichung-Schwellwert verschieden ist, und eine Überladung eines Akkumulators in dem besagten Zweig detektiert wird in Abhängigkeit von der besagten ersten Stromabweichung, von der besagten zweiten Stromabweichung und von dem ermittelten Ladezustand-Niveau.

5. Verfahren zum Detektieren einer Überladung eines Akkumulators (11) gemäß irgendeinem der vorherigen Ansprüche, gemäß welchem man mindestens einen ersten Bereich (ZI) von Ladezustand-Niveaus und einen zweiten Bereich (ZII), welcher hinter dem besagten ersten Bereich ist, von Ladezustand-Niveaus unterscheidet und, falls ein Ladezustand-Niveau des Zweiges in dem zweiten Bereich detektiert wird, eine Überladung eines Akkumulators in dem besagten Zweig detektiert wird, falls die Stromabweichung, welche in dem besagten Zweig detektiert wird, zuerst einen ersten Schwellwert übersteigt und später einen zweiten Schwellwert übersteigt, wobei das Vorzeichen des ersten und des zweiten Schwellwerts entgegengesetzt sind.

6. Verfahren zum Detektieren einer Überladung eines Akkumulators (11) gemäß Anspruch 5, wobei der erste Schwellwert gleich dem Negativen des zweiten Schwellwerts ist.

7. Verfahren zum Detektieren einer Überladung eines Akkumulators (11) gemäß irgendeinem der Ansprüche 5 oder 6, gemäß welchem eine Überladung eines Akkumulators (11) in dem besagten Zweig (B1, ..., BN) detektiert wird, für ein Ladezustand-Niveau, welches in dem ersten Bereich ermittelt wird, sobald die erste Stromabweichung, welche in dem besagten Zweig identifiziert wird, den ersten Schwellwert übersteigt.

8. Vorrichtung zum Detektieren (1) einer Überladung eines Akkumulators (11) einer Batterie (10), welche eine Gruppe von parallelen Zweigen (B1, ..., BN) aufweist, wobei jeder Zweig Akkumulatoren aufweist, welche in Reihe angeordnet sind, wobei die besagte Vorrichtung angepasst ist, um die Messungen von Strömen zu sammeln, welche in den Zweigen der Batterie fließen, um mindestens eine Stromabweichung in einem Zweig der besagten Gruppe von Zweigen im Vergleich zu mindestens einem anderen Zweig der besagten Gruppe von Zweigen in Abhängigkeit von den gesammelten Strommessungen zu identifizieren, um ein Ladezustand-Niveau des besagten Zweigs zu ermitteln, und um eine Überladung eines Akkumulators in dem besagten Zweig in Abhängigkeit von zumindest der besagten identifizierten Stromabweichung und von dem ermittelten Ladezustand-Niveau zu detektieren.

9. Vorrichtung zum Detektieren (1) einer Überladung eines Akkumulators (11) gemäß Anspruch 8, welche angepasst ist, um die besagte Überladung zu detektieren zumindest mittels Testens einer Bedingung, welche die identifizierte Stromabweichung betrifft, wobei die besagte zu testende Bedingung, welche die identifizierte Stromabweichung betrifft, abhängig von dem ermittelten Ladezustand-Niveau ist.

**10.** Vorrichtung zum Detektieren (1) einer Überladung eines Akkumulators (11) gemäß Anspruch 8 oder 9, welche angepasst ist, um eine Differenz zu berechnen zwischen dem Strom, welcher in dem besagten Zweig gemessen wird, und einem Referenzstrom, welcher in Abhängigkeit von zumindest dem Strom ermittelt wird, welcher in dem anderen Zweig gemessen wird, um die besagte Differenz mit einem Schwellwert zu vergleichen, und um eine Überladung eines Akkumulators in dem besagten Zweig (B1, ..., BN) zu detektieren in Abhängigkeit von dem Ergebnis des besagten Vergleichs und von dem ermittelten Ladezustand-Niveau.

**11.** Vorrichtung zum Detektieren (1) einer Überladung eines Akkumulators (11) gemäß irgendeinem der Ansprüche 8 bis 10, welche angepasst ist, um eine erste Stromabweichung in dem besagten Zweig zu einer ersten Zeit zu identifizieren und diese mit einem ersten Stromabweichung-Schwellwert zu vergleichen, um eine zweite Stromabweichung in dem besagten Zweig zu einer zweiten Zeit zu identifizieren und diese mit einem zweiten Stromabweichung-Schwellwert zu vergleichen, welcher von dem ersten Stromabweichung-Schwellwert verschieden ist, und um eine Überladung eines Akkumulators in dem besagten Zweig (B1, ..., BN) zu detektieren in Abhängigkeit von der besagten ersten Stromabweichung, von der besagten zweiten Stromabweichung und von dem ermittelten Ladezustand-Niveau.

**12.** Vorrichtung zum Detektieren (1) einer Überladung eines Akkumulators (11) gemäß irgendeinem der Ansprüche 8 bis 11, welche angepasst ist, um, wobei ein erster Bereich von Ladezustand-Niveaus (ZI) und ein zweiter Bereich (ZII), welcher hinter dem besagten ersten Bereich ist, von Ladezustand-Niveaus des Zweiges definiert sind, eine Überladung eines Akkumulators in dem besagten Zweig zu detektieren, falls, wobei das Ladezustand-Niveau des Zweiges in dem zweiten Bereich ist, die Stromabweichung, welche in dem besagten Zweig detektiert wird, zuerst einen ersten Schwellwert übersteigt und später einen zweiten Schwellwert übersteigt, wobei das Vorzeichen des ersten und des zweiten Schwellwerts entgegengesetzt sind.

**13.** Vorrichtung zum Detektieren (1) einer Überladung eines Akkumulators (11) gemäß Anspruch 12, wobei der erste Schwellwert gleich dem Negativen des zweiten Schwellwerts ist.

**14.** Vorrichtung zum Detektieren (1) einer Überladung eines Akkumulators (11) gemäß irgendeinem von Anspruch 12 oder 13, welche angepasst ist, um eine Überladung eines Akkumulators (11) in dem besagten Zweig (B1, ..., BN) zu detektieren, sobald die Stromabweichung, welche in dem besagten Zweig identifiziert wird, den ersten Schwellwert übersteigt, für ein Ladezustand-Niveau, welches in dem ersten Bereich ermittelt wird.

**15.** Computerprogrammprodukt, welches Anweisungen aufweist, welche die Vorrichtung gemäß Anspruch 8 veranlassen, die Schritte des Verfahrens gemäß Anspruch 1 auszuführen.

**Claims**

**1.** An overcharge detection method for detecting an overcharging of an accumulator (11) of a battery (10) comprising a set of parallel branches (B1, ..., BN), each branch comprising accumulators disposed in series, said method comprising the following steps:

- (i) collecting the measurements of the currents flowing through the branches of the battery;
- (ii) identifying at least one variation in current in one branch of the said set of branches with respect to at least one other branch of the said set of branches as a function of the measurements of current collected;
- (iii) determining a level of state of charge of the said branch; and
- (iv) detecting an overcharging of an accumulator in the said branch as a function of at least the said variation in current identified and of the level of state of charge determined.

**2.** An overcharge detection method for detecting an overcharging of an accumulator (11) according to claim 1, in which the detection of an overcharging includes the testing of at least one condition relative to the variation in current identified, the said condition to be tested relative to the variation in current identified being a function of the level of state of charge determined.

**3.** An overcharge detection method for detecting an overcharging of an accumulator (11) according to claim 1 or claim 2, based on which:

- a difference between the current measured in the said branch (B1, ..., BN) and a reference current determined as a function of at least the current measured in the other branch is calculated;
- the said difference is compared to a threshold value; and
- an overcharging of an accumulator in the said branch is detected based on the result of the said comparison and the level of state of charge determined.

**4.** An overcharge detection method for detecting an overcharging of an accumulator (11) according to any one of the preceding claims, in which a first variation in current identified in the said branch (B1,..., BN) at a first time instant is compared with a first threshold value of current variation, a second variation in current identified in the said branch at a second time instant is compared with a second current variation threshold value that is distinct from the first current variation threshold value, and an overcharging of an accumulator in the said branch is detected as a function of the said first variation in current, of the said second variation in current and of the level of state of charge determined.

5. An overcharge detection method for detecting an overcharging of an accumulator (11) according to any one of the preceding claims, based on which one can distinguish at least a first range (ZI) of state of charge levels and a second range (ZII), subsequent to the said first range, of state of charge levels, and if a state of charge level of the branch is determined to be in the second range, an overcharging of an accumulator in the said branch is detected if the variation in current identified in the said branch firstly surpasses a first threshold and subsequently surpasses a second threshold, the first and second threshold values having opposite signs.

6. An overcharge detection method for detecting an overcharging of an accumulator (11) according to claim 5, the first threshold value being equal to the opposite of the second threshold value.

7. An overcharge detection method for detecting an overcharging of an accumulator according to any one of claims 5 or 6, based on which an overcharging of an accumulator (11) in the said branch (B1, ..., BN) is detected, for a level of charge state determined to be in the first range, as soon as the variation in current identified in the said branch surpasses the first threshold value.

8. An overcharge detection device (1) for detecting an overcharging of an accumulator (11) of a battery (10) comprising a set of parallel branches (B1,..., BN), each branch comprising accumulators disposed in series, the said device being suitable for and capable of collecting the measurements of the currents flowing through the branches of the battery; of identifying at least one variation in current in one branch of the said set of branches with respect to at least one other branch of the said set of branches as a function of the measurements of current collected; of determining a level of state of charge of the said branch; and of detecting an overcharging of an accumulator in the said branch as a function of at least the said variation in current identified and of the level of state of charge determined.

9. An overcharge detection device (1) for detecting an overcharging of an accumulator (11) according to claim 8, suitable for and capable of detecting the said overcharging at least by the testing of at least one condition relative to the variation in current identified, the said condition to be tested relative to the variation in current identified being a function of the level of state of charge determined.

10. An overcharge detection device (1) for detecting an overcharging of an accumulator (11) according to claim 8 or 9, suitable for and capable of calculating a difference between the current measured in the said branch and a reference current determined as a function of at least the current measured in the other branch, of comparing the said difference to a threshold value; and of detecting an overcharging of an accumulator in the said branch (B1,..., BN) based on the result of the said comparison and the level of state of charge determined.

11. An overcharge detection device (1) for detecting an overcharging of an accumulator (11) according to one any one of claims 8 to 10, suitable for and capable of identifying a first variation in current in the said branch at a first time instant and of comparing it with a first threshold value of variation in current, of identifying a second variation in current in the said branch at a second time instant and of comparing it with a second current variation threshold value that is distinct from the first current variation threshold value, and of detecting an overcharging of an accumulator in the said branch (B1,..., BN) as a function of the said first variation in current, of the said second variation in current, and of the level of state of charge determined.

12. An overcharge detection device (1) for detecting an overcharging of an accumulator (11) according to any one of claims 8 to 11, suitable for and capable of, a first range of state of charge levels (ZI) and a second range (ZII), subsequent to the said first range, of state of charge levels of the branch, being defined, detecting an overcharging of an accumulator in the said branch if, the level of state of charge of the branch being in the second range, the variation in current identified in the said branch firstly surpasses a first threshold value and subsequently surpasses a second threshold value, the first and second threshold values having opposite signs.

13. An overcharge detection device (1) for detecting an overcharging of an accumulator (11) according to claim 12, in which the first threshold value is equal to the opposite of the second threshold value.

14. An overcharge detection device (1) for detecting an overcharging of an accumulator according to any one of claims 12 or 13, suitable for and capable of detecting an overcharging of an accumulator (11) in the said branch (B1,..., BN), as soon as the variation in current identified in the said branch surpasses the first threshold value, for a state of charge level determined in the first range.

15. A computer program product comprising instructions which cause the device according to claim 8 to perform the method steps according to claim 1.

## FIG.1

## FIG.2

100

-101-

-102-

-103-

FIG.3

## RÉFÉRENCES CITÉES DANS LA DESCRIPTION

**Documents brevets cités dans la description**

- EP 13008739 A2

- US 2011298626 A1